Europäisches Patentamt

European Patent Office

Office européen des brevets

(19)

(11) **EP 0 696 065 A2**

(12) **EUROPEAN PATENT APPLICATION**

(43) Date of publication:
07.02.1996 Bulletin 1996/06

(51) Int Cl.6: **H01L 29/08**

(21) Application number: 95304592.9

(22) Date of filing: 29.06.1995

(84) Designated Contracting States:
**DE FR GB NL**

(30) Priority: **03.08.1994 GB 9415718**

(71) Applicant: **HITACHI EUROPE LIMITED**
**Maidenhead, Berkshire, SL6 8YA (GB)**

(72) Inventor: **Nakazato, Kazuo**
**Cambridge, CB1 4PA (GB)**

(74) Representative: **Read, Matthew Charles et al**
**London EC1A 7DH (GB)**

(54) **Conduction control device**

(57)   A conduction control device, for example a single electron transistor consists of a source 1, a drain 2 and a charge-receiving island 3 separated from the source and drain by respective tunnel barrier junctions TJ1, TJ2. The device is constructed on the nanometre scale, and the charge on the island 3 is limited by the Coulomb blockade effect to a small discrete number of electrons. A gate electrode 4 overlies the island 3. In order to provide a high gate/drain gain, a voltage drop region 15 is connected in series between the tunnel barrier junction TJ2 and the drain 2 so as to increase the effective Coulomb gap voltage $V_c$.

## Description

This invention relates to a conduction control device and has particular but not exclusive application to improving the voltage gain of a single-electron logic device.

Modern technology enables structures to be fabricated on a nano-scale with an electrical capacitance sufficiently small that the charging effects of discrete electrons can be observed. When an electron attempts to enter on to a nano-scale conductive island on a substrate, and the change of the charging energy of the island becomes larger than the energy $k_BT$ of the thermal fluctuations, a significant charging of the island capacitance occurs so that the electron entry is strongly suppressed. This is known as the Coulomb Blockade effect and attracted much interest when it was demonstrated that a single electron transistor could be produced [Fulton, T.A. and Dolan G.J.: "Observation of Single-Electron Charging Effects in Small Tunnel Junctions", Phys. Rev. Lett., 1987, 59, pp 109 - 112]. A turnstile for the transfer of individual electrons has also recently been demonstrated [Geerligs, L.J Anderegg, V.F., Holweg, P.A.M., Mooij, J.E., Pothier, H., Esteve, D., Urbina, C., and Devoret, M.H.,: "Frequency-Locked Turnstile Device for Single Electrons", Phys. Rev. Lett., 1990, 64 pp 2691-2694].

Also, reference is directed to Averin, D.V., and Likharev, K.K.: "Single electronics: A Correlated Transfer of Single Electrons and Cooper Pairs in Systems of Small Tunnel Junctions", in B.L. Altshuler, P.A. Lee, and R.A. Webb (Ed); "Mesoscopic Phenomena in Solids", (Elsevier, Amsterdam, 1991), pp 173 - 271, and to Averin, D.V.,and Likharev, K.K.: "Possible Applications of Single Charge Tunnelling" in H. Grabert and M.H. Devoret: "Single Charge Tunnelling" (Plenum Press, New York, 1992) pp 311-332.

Reference is furthermore directed to our EP-A-0562751 and WO94/15340.

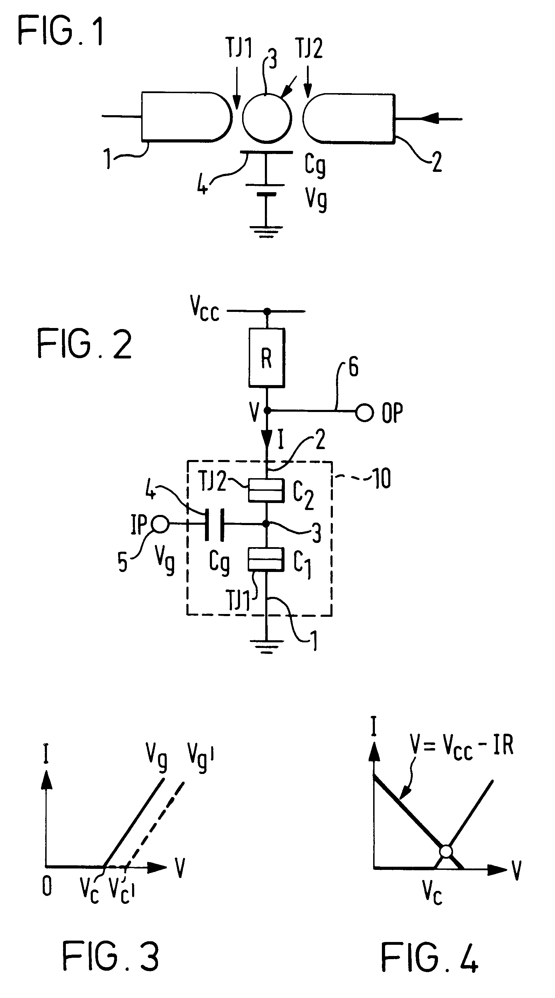

A single electron transistor is shown schematically in Figure 1. The device consists of a nanometre scale conductive structure formed on a generally insulating substrate so to define a source region 1, a drain region 2 and a charge-receiving island 3 between the source and drain regions 1, 2. An overlying gate electrode 4 shown schematically, is capacitively coupled to the island 3 so as to form a gate capacitor $C_g$. A gate voltage $V_g$ is applied to the capacitor $C_g$. The insulating gaps between the conductive regions 1, 2, 3 form tunnel junctions TJ1, TJ2. The tunnel junctions act as barriers to electron flow but, by the application of a suitable bias, electrons can be made to tunnel individually from the source 1 to the island 3 through the first barrier presented by tunnel junction TJ1, and thence through the barrier presented by junction TJ2 to the drain 2. The electron flow is controlled on an electron-by-electron basis, because the small scale of the structure gives rise to the Coulomb Blockade effect, so that the island can be configured to accept individual electrons sequentially. A more detailed discussion of the device is given by Averin and Likharev *supra*.

Referring now to Figure 2, this shows a logic circuit that includes the single electron transistor shown in Figure 1, within hatched outline 10. The drain-source path of the transistor 10 is connected in series with a resistance R across a rail voltage $V_{cc}$. An input IP is applied to the gate electrode 4 and an output OP is taken from the series connection of the resistor R and the transistor 10, at terminal 6.

In the single electron transistor 10, the tunnelling junctions TJ1, TJ2, as far as the circuit characteristics are concerned, primarily exhibit a capacitance $C_1$ and $C_2$ respectively.

The source-drain voltage/current characteristic of the single electron transistor 10 is shown in Figure 3. Due to the Coulomb Blockade effect, no current flows through the device below a threshold voltage $V_c$ known as the Coulomb gap voltage. Above the Coulomb gap voltage $V_c$, current flows as a function of applied voltage, electron by electron. The Coulomb gap voltage can be varied by changing the gate voltage, and when changed from $V_g$ to $V_{g'}$, the Coulomb gap voltage changes to a value $V_{c'}$ as shown in Figure 3. Referring now to Figure 4, this shows that the output voltage V of the inverter circuit of Figure 2 is given by the cross point between the characteristic curve of Figure 3 and the curve $V_{cc} - IR = V$ where $V_{cc}$ is the rail voltage R is the load resistance and I is the current. The output voltage V is very close to the Coulomb gap voltage. Thus, by changing the gate voltage, so as to produce a change in the Coulomb gap voltage $V_c$, the output voltage V can be varied as a function of the gate voltage $V_g$.

A problem with a conventional single electron transistor is that the gate-drain voltage gain is less than unity, as now will be explained. It is to be appreciated that the characteristics of the single electron transistor need to be considered in terms of the addition or subtraction of electrons on the island 3. Thus, considering the addition of an electron, a gate voltage should be changed by $e/C_g$ where -e is the charge of a single electron (e > o). This gate voltage change will produce an output voltage change of $e/C_\Sigma$, where $C_\Sigma = C_1 + C_2 + C_g$. Therefore, the overall gate-drain voltage gain is given by the ratio of these two values:

$$C_g/C_\Sigma = C_g/(C_g + C_1 + C_2)$$

It can be seen that this expression necessarily is less than unity.

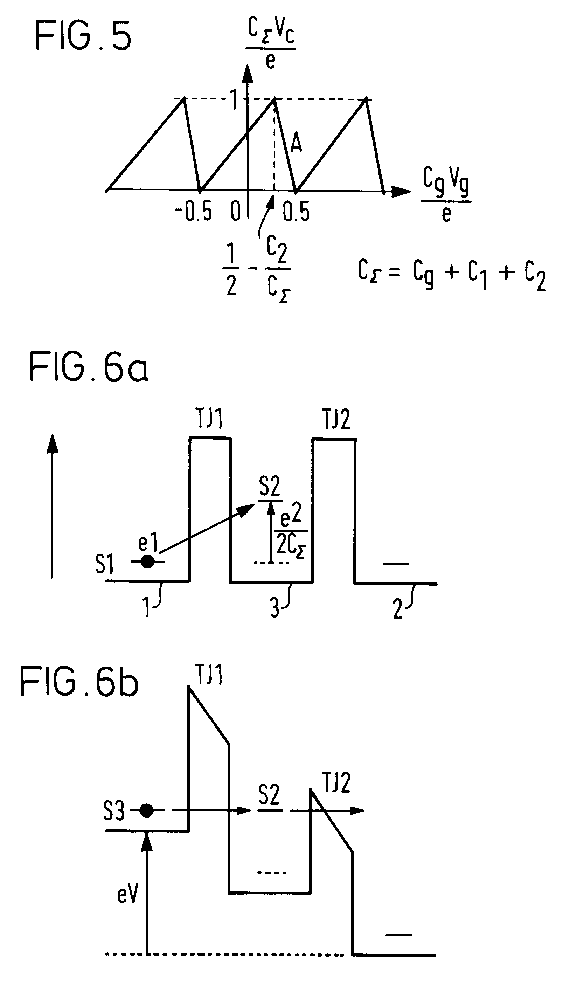

Referring now to Figure 5, the shows a relationship of the gate voltage $V_g$ and the Coulomb gap voltage $V_c$ in more detail and illustrates the effects produced by induced charges on the capacitors and the electron occupation in the island. Figure 5 is in effect a plot of the source/drain voltage V as a function of the gate voltage $V_g$. In the region A shown in the graph, the differential voltage gain exceeds unity but the gain and the operating region is extremely small and cannot be used as a practical matter. Reference is directed to M. I. Lutwyche and Y. Wada, "Estimate of the ultimate performance of the single-electron transistor, "J. Appl. Phys. 75, 3654 (1994). It can also be shown that the graph has a multi-path "saw-tooth" configuration as a result of charges induced on the capacitors and the single electron occupation in the device. Thus, if an attempt is made to operate the device in this region of the graph, there is a significant risk that the circuit will become unstable. Since the region A repeats at different ranges of $V_g$ it is difficult to determine which actual range is selected.

The present invention provides a solution to these problems.

The invention provides a conduction control device including a source region, a charge-receiving region for charge from the source region, a drain region for charge from the charge-receiving region, first and second barrier regions between the charge-receiving region and the source and drain regions respectively, the charge on the charge-receiving region being limited by Coulomb Blockade to a given energy level relative to a base level, means for raising the energy of the source region to a level above the base level for causing charge to tunnel through the first barrier into the charge receiving region, and means for lowering the energy of the drain region below the base level so as to promote charge in the charge-receiving region to tunnel through the second barrier to the drain region.

Conveniently, the means for lowering the energy of the drain region includes means for producing a voltage drop connected between the second barrier and the drain region.

The device is conveniently constructed on a nano-scale on a substrate so as to include a channel having a relatively high conductivity, the first and second barriers being spaced apart along the channel whereby relatively conductive regions of the channel define the source, charge-receiving and drain regions, and the voltage drop region comprises means for defining a relatively high impedance region in the channel between the second barrier and the drain region.

The voltage drop region may comprise a region of the channel doped to produce a relatively high impedance depletion region.

The channel may include a region containing a multiple tunnel junction structure that extends between the source region and the drain region, the structure comprising a plurality of tunnel junctions with a plurality of charge receiving islands between them, with a control electrode adjacent the multiple tunnel junction structure.

In order that the invention may be more fully understood embodiments thereof will now be described with reference to the accompanying drawings in which:

Figure 1 is a schematic diagram of an known single electron transistor;
Figure 2 is a schematic circuit diagram of the transistor of Figure 1 incorporated in a logic circuit;
Figure 3 illustrates the Coulomb Blockade limited voltage-current characteristic of the source-drain path, as a function of gate voltage;
Figure 4 is a graph showing the output voltage characteristics of the circuit of Figure 2;
Figure 5 is a graph of the voltage gain of the transistor shown in Figure 2;
Figure 6a is an energy diagram of the single electron transistor of Figure 2 under zero applied bias;
Figure 6b corresponds to the diagram of Figure 6a but with an applied source-drain bias;
Figure 7 illustrates a first embodiment of the invention;
Figure 8 is a graph of an energy diagram associated with the device of Figure 7;
Figure 9 is a schematic diagram of an alternative embodiment of the invention, with a split-gate structure overlying the tunnel barriers;
Figure 10 illustrates an alternative embodiment of the invention in which the depletion region of Figures 7 and 9 is replaced by a partially etched channel region;
Figure 11 illustrates an alternative embodiment in which the voltage drop region is produced by a region of reduced channel width;
Figure 12 illustrates yet another embodiment of the invention;
Figure 13 illustrates an alternative embodiment utilising a multiple tunnel junction device;
Figure 14a shows the energy diagram of the device of Figure 13 under zero bias; and
Figure 14b illustrates an energy diagram corresponding to Figure 14a but with an applied drain-source bias.

Before describing embodiments of the invention, the various energy states in the single electron transistor of Figure 2 will firstly be described with reference to the energy diagrams shown in Figure 6.

Referring to Figure 6a, this shows an energy diagram taken along the source-drain path of the transistor 10 shown in Figure 2. It will be seen that a well is formed by potential barriers associated with the tunnel junctions TJ1, TJ2, which isolate the relatively low energy state of the island 3 from the low energy states of the source and drain 1, 2. Due to Coulomb Blockade, when an electron enters the island 3 by tunnelling through the barrier TJ1, the energy on the island 3 increases. The charging energy is given by:

$$e^2/2C_\Sigma$$

In order for an electron el at state S1 in the source 1 to tunnel through the barrier associated with the junction TJ1, to the island 3, it is necessary for a voltage to be applied to the device in order to lift the energy level for electron e1 in the source by an amount eV, as shown in Figure 6b so that the electron in state S3 can tunnel through the barrier TJ1 into state S2 on the island 3.

As shown in Figure 6b, the gain eV of energy from the external bias can overcome the charging energy of the island and electrons can pass through the transistor. Since the voltage drop produced by the external bias occurs equally at the two junctions TJ1, TJ2, the Coulomb gap voltage $V_c$ required to start electron transport is given by the following equation:

$$eV_c/2 = e^2/2C_\Sigma$$

This can be rewritten as follows:

$$V_c = e/C_\Sigma$$

Therefore, the maximum Coulomb gap voltage $V_c$ is set by the various capacitances of the single electron transistor, which corresponds to the maximum value shown on the Y-axis of Figure 5.

In accordance with the present invention, it has been appreciated that if the effective Coulomb gap voltage $V_c$ is increased, the voltage gain of the transistor will be increased also.

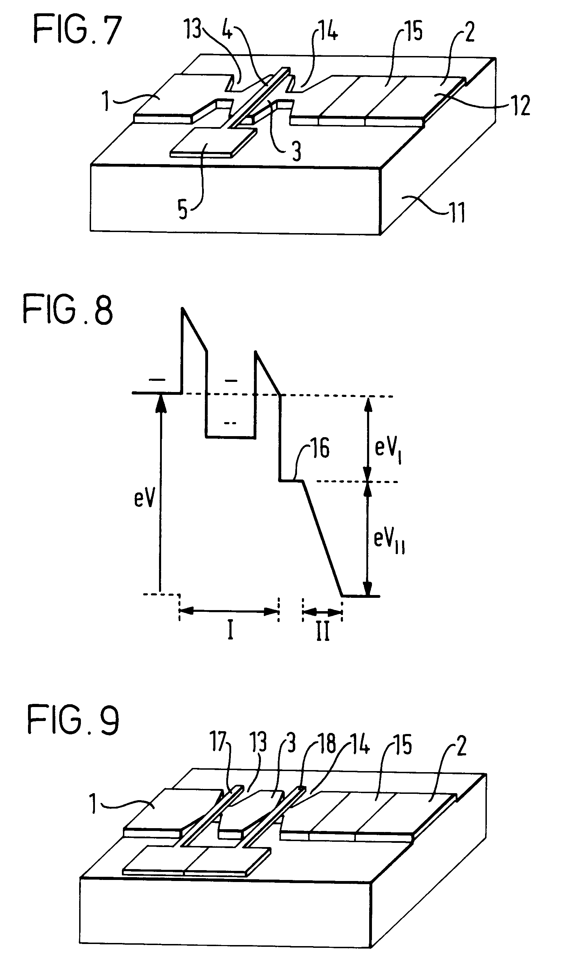

Referring now to Figure 7 this shows a first embodiment of the invention which comprises a semiconductor substrate 11 on which is formed a conducting channel 12. Typically, the substrate is formed of GaAs and the channel is formed by a GaAs/GaAlAs layer interface that provides a two dimensional electron gas in the substrate along the length of the channel, in a manner well known *per se*. The single electron transistor 10 is formed in the channel 12 and consists of source region 1, drain 2 and an island 3 separated from the source and drain regions by first and second tunnel barriers TJ1, TJ2 that are constituted by width restrictions 13, 14 in channel 12. Typically, the layer structure for the channel 12 is grown by molecular beam epitaxy (MBE) and patterned by lithography and etching to define the channel and the width restrictions 13, 14 that provide the barriers TJ1, TJ2. An overlying gate electrode 4 with a side contact 5, is arranged overlying the island 3. The gate 4 is typically made of metal and formed by a conventional lift-off method.

In accordance with the invention, a region 15 of the channel 12 is subject to ion implantation to form a lightly implanted region that increases the impedance of the underlying two dimensional electron gas by depletion. The region 15 may be formed using an implantation technique, through a resist mask, for example using Be ions. The region 15, thus constitutes an impedance connected in series between the tunnel junction TJ2 and the drain 2 of the transistor, so as to provide a voltage drop region.

Referring now to Figure 8, this shows the energy diagram associated with the device shown in Figure 7, with a source-drain bias voltage applied. When compared with the energy diagram of the prior art shown in Figure 6, it can be seen that the device according to the invention gives rise to a higher Coulomb gap voltage. The applied bias voltage V as shown in Figure 8 produces a voltage drop $V_I$ across the first and second tunnel barriers TJ1, TJ2, such that the energy level of the source 1 is raised to a level greater than a base level 16, by an amount $eV_I$. Additionally, the effect of the voltage drop region 15 is to lower the energy of the drain region 2 by an amount $eV_{II}$ below the base level 16.

When the voltage-drop ratio is given by $\alpha = V_{II}/V_I$, the Coulomb gap voltage is enhanced to $(1+\alpha) V_{co}$ where $V_{co}$ is the Coulomb gap voltage without voltage-drop region 15. The ratio $\alpha$ is determined by the ratio of effective capacitance of the two regions I, II of Figure 8, where $\alpha = C_I/C_{II}$. It is not necessary to have a tunnel barrier for the voltage drop region 15; it can be simply realised by a space-charge region. The situation can be considered similar to a conventional bipolar transistor where the collector-base depletion region creates a high voltage gain.

Referring now to Figure 9, a modification is shown in which the single gate 4 of Figure 7 is replaced by a split gate arrangement that includes two gates 17, 18, each of the same general construction as gate 4, but configured to overlie the tunnel barrier regions TJ1, TJ2 respectively. By applying control voltages to the gates 17, 18, the barrier heights associated with the junctions TJ1, TJ2 can be controlled individually so as to increase or decrease the probability of charge transfer from the source 1 to the island 3, and also from the island 3 to the drain 2. The device includes a voltage drop region 15 formed in the same way as described with reference to Figure 7. In this configuration the Coulomb blockade is controlled by the barrier heights, and the Coulomb gap voltage - gate voltage characteristic gives an ideal transfer characteristic of the inverter circuit instead of the "saw-tooth" characteristic (Figure 5) in a single-electron transistor. Furthermore, the turning point of the transfer characteristic is determined by a certain value of barrier heights and insensitive to off-set charges; unexpected charges due to the impurity traps surrounding the island 3.

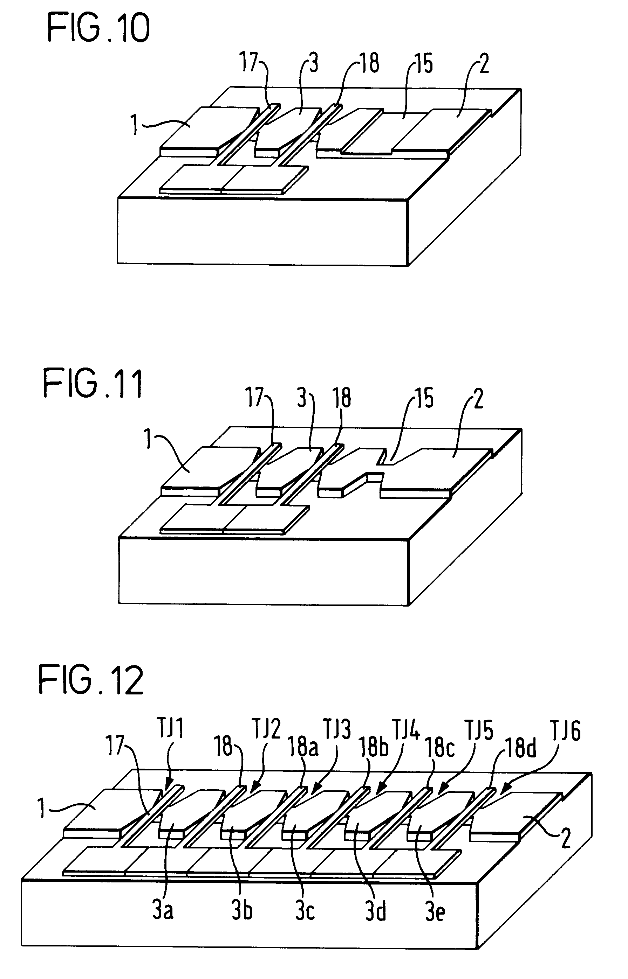

In Figure 10, a modification of Figure 9 is shown in which the voltage drop region is formed by selective etching of a surface region of the channel 12 which, as will be apparent to those skilled in the art, increases the impedance of the channel in region 15.

In Figure 11, a modification to the embodiment of Figure 9 is shown, in which the voltage drop region 15 is formed by a width restriction in the channel so as to increase its impedance.

Referring now to Figure 12, this shows a modification in which a plurality of islands 3a, 3b...3e are coupled between the source 1 and drain 2. A tunnel barrier TJ1...TJ6 is provided between each adjacent island and also between the source and drain 1, 2. The tunnel junctions TJ3 to TJ6 are provided with respective control electrodes 18a - 18d and can be used as voltage drop regions to increase the effective Coulomb Blockade voltage $V_c$ thereby to increase the voltage gain of the device. In this configuration, the several tunnel junctions suppress co-tunnelling effects; electron tunnelling simultaneously across more than two junctions. The configuration of Figure 12 can be combined with the structures in Figure 9 to 11.

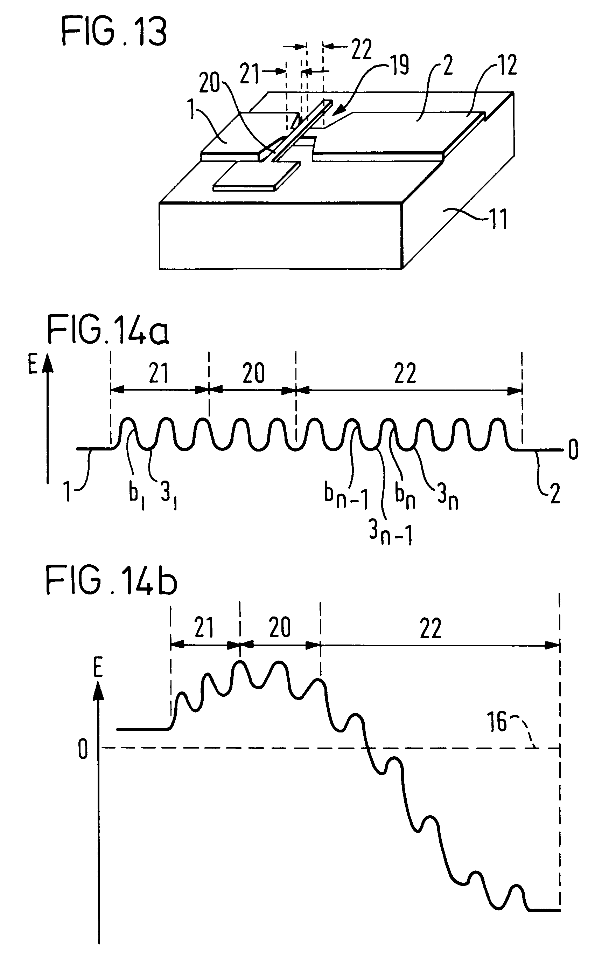

A further example of the device according to the invention is shown in Figure 13, in which, the channel 12 is formed of so-called δ-doped material [K. Nakazato, T. J. Thornton, J. White, and H. Ahmed, "Single-Electron Effects in side gating in δ-doped layers," Appl. Phys. Lett. 61, 3145 (1992)]. In such a δ-doped layer, dopant layer is introduced into only one atomic layer and the resulting material is said to be δ-doped. The structure provides an essentially two dimensional electron gas along the length of the channel. However, in the region of width restriction 19, a multiple-tunnel junction (MTJ) is formed by virtue of the constriction [K. Nakazato, R. J. Blaike, and H. Ahmed, "Single-electron memory", J. Appl. Phys. 75, 5123 (1994)]. This is discussed in more detail also in our WO94/15340. The gate electrode 20 is arranged asymmetrically over the resulting MTJ in constriction 19 such that, as shown in Figure 13, a relatively short length barrier region 21 is provided between the source 1 and the gate 20 whereas a relatively long length voltage drop region 22 is provided between the gate 20 and the drain 2.

Referring to Figure 14a, an energy diagram for the device of Figure 13 is shown under conditions of zero bias. As explained in Nakazato et al *supra* the multiple tunnel junction device is thought to contain a plurality of tunnel junctions that bound adjacent islands in the electron gas and that the tunnel junctions are formed by impurity potential in the channel. The resulting energy diagram for the MTJ is as shown in Figure 14a and comprises a plurality of closely spaced energy barriers $b_n$ between which conducting islands $3_n$ are formed in the electron gas.

Figure 14b shows the device when a drain-source bias is applied. The resulting applied bias V raises the energy level of the source 1 above the base level 16 by $eV_I$ and causes the drain 2 to have its energy level reduced between the base level 16 by $eV_{II}$. As a result, the effective Coulomb Blockade voltage $V_c$ is increased as compared with the prior art. Electrons are then caused to tunnel through the barriers b in the barrier region 21 under the control of gate electrode 20. The structure shown in Figure 13 is very compact because only one constriction is required in order to provide the barrier region 21 and the voltage drop region 22.

Many modifications and variations of the invention will be apparent to those skilled in the art. For example, the devices can be made using vertical layered structures instead of laterally patterned structures as described hereinbefore. Suitable MTJ structures are described in GB-A-2284299. Furthermore, any suitable semiconductor material or other material can be used to produce the structures and whilst GaAs has been described hereinbefore by way of example, silicon fabrication technology could also be used as described in our WO94/15340 *supra*. The devices according to the invention are not restricted to use in logic circuits but are applicable to any circuits which require high voltage gain.

**Claims**

1. A conduction control device including a source region (1), a charge-receiving region (3) for charge from the source region, a drain region (2) for charge from the charge-receiving region, first and second barrier regions (13, 14) between the charge-receiving region and the source and drain regions respectively, the charge in the charge-receiving region being limited by Coulomb Blockade to a given energy level relative to a base energy level (16), means for raising the energy of the source region above the base level for causing charge to tunnel through the first barrier into the charge-receiving region, and **characterised by** means (15) for lowering the energy of the drain region (2) below the base level (16) so as to promote charge in the charge-receiving region (3) to tunnel through the second barrier (14) to the drain region.

2. A device according to claim 1 wherein the means for lowering the energy of the drain region includes means (15) for producing a voltage drop, connected in series between the second barrier (14) and the drain region (2).

3. A device according to claim 1 or 2 including a substrate (11), means defining a channel (12) with a relatively high conductivity, means (13, 14) defining the first and second barriers spaced apart along the channel whereby relatively conductive regions of the channel define said source (1), charge-receiving (3) and drain regions (2), and said voltage drop region comprises means for defining a relatively high impedance region (15) in the channel between the second barrier and the drain region.

4. A device according to claim 3 wherein the first and second barrier regions comprise regions (13, 14) of reduced width in the channel (12).

5. A device according to claim 3 or 4 including a layer structure on the substrate for producing an essentially two dimensional electron gas along the length of the channel (12).

6. A device according to claim 5 wherein the voltage drop region (15) comprises a region of the channel doped to produce a relatively high impedance depletion region in the electron gas.

7. A device according to claim 5 wherein the voltage drop region (15) has been defined by partial removal of a portion of said layer structure.

8. A device according to claim 3, 4 or 5 wherein the voltage drop region (15) is defined by a region of reduced width in the channel.

**9.** A device according to claim 8 wherein the voltage drop region includes a plurality of regions (TJ3...TJ6) of reduced width along the length of the channel.

**10.** A device according to claim 8 or 9 including control electrode means (17, 18) associated with the or each channel width restriction for controlling the barrier height thereof.

**11.** A device according to any preceding claim including gate electrode means (14) capacitively coupled to the charging region.

**12.** A device according to any preceding claim including first and second control electrode means (17, 18) associated with the first and second barriers (13, 14) respectively for controlling the barrier heights thereof.

**13.** A device according to claim 3 wherein the channel (12) includes a region (19) containing a multiple tunnel junction structure that extends between the source region (1) and the drain region (2), said structure comprising a plurality of spaced tunnel junctions with a plurality of charge receiving islands therebetween, and a control electrode (20) overlying the multiple tunnel junction structure.

**14.** A device according to claim 13 wherein the multiple tunnel junction structure defines a barrier region (21) between the source region and said control electrode, and a voltage drop region (22) between the control electrode and the drain region.

**15.** A device according to any preceding claim and comprising a single electron transistor (10).

**16.** A device according to any preceding claim having its source-drain path connected in series with a load impedance (R) between rail voltage sources ($V_{cc}$), whereby to provide a logic circuit element.

FIG.1

FIG.2

FIG.3

FIG.4

FIG.5

$$C_\Sigma = C_g + C_1 + C_2$$

FIG.6a

FIG.6b

FIG.7

FIG.8

FIG.9

FIG.10

FIG.11

FIG.12

# FIG.13

# FIG.14a

# FIG.14b